# EUROPEAN PATENT SPECIFICATION

(11) **EP 1 605 585 B1**
(45) Date of publication and mention of the grant of the patent: **04.07.2012**
(21) Application number: 05252027.7
(22) Date of filing: 31.03.2005
(51) Int. Cl.: H03D 9/06

(54) **Harmonic mixer using anti parallel diodes**
Harmonischer Mischer unter Verwendung von antiparallelgeschalteten Dioden
Mélangeur harmonique utilisant diodes connectées en anti-parallèle

(30) Priority: 31.03.2004 JP 2004105684
(43) Date of publication of application: 14.12.2005
(73) Proprietor: Sumitomo Electric Device Innovations, Inc., Yokohama-shi Kanagawa 244-0845 (JP)
(72) Inventor: Nakano, Hiroshi, c/o Eudyna Devices, Inc., Nakakoma-gun Yamanashi 409-3883 (JP); Hirachi, Yasutake, c/o Eudyna Devices, Inc., Nakakoma-gun Yamanashi 409-3883 (JP)
(74) Representative: Hitching, Peter Matthew

(56) References cited:
- EP-A- 0 081 818
- EP-A- 0 495 598
- WO-A-02/07304
- WO-A-99/14853

## Description

### BACKGROUND OF THE INVENTION

### 1. Field of the Invention

This invention generally relates to a harmonic mixer and a radio communication device having the same, and more particularly, to transmission technology suitable for a high frequency range of 30GHz or more.

### 2. Description of the Related Art

Recently, there has been considerable activity in the research and development of communication technology using the submillimeter-wave frequency range or millimeter-wave frequency range as high as 30 GHz or more. In the above-mentioned high frequency range, it is difficult to generate the stabilized local oscillation frequency. The high-quality radio communication cannot be realized unless the stabilized local oscillation frequency is available on both the transmitter and receiver.

Japanese Patent Application Publication No. 2001-53640 (hereinafter referred to as Document 1) describes a technique for transmitting an unmodulated carrier having a local oscillation frequency together with a modulated radio signal. In the receiver, the received unmodulated carrier is used as the local oscillation frequency to demodulate the modulated radio signal. It is not necessary to provide a high-accuracy local oscillator on the receiver. It is thus possible to simplify the structure of the receiver. In the case where the unmodulated carrier and the modulated radio carrier are affected by the same environmental factor such as temperature change, the effect of the environmental factor (fluctuations due to the temperature change) can be cancelled by demodulating with the received unmodulated carrier, and an excellent communication quality can be thus provided.

The invention disclosed in Document 1, however, employs a local oscillator that generates the oscillation frequency identical to that of the unmodulated carrier to be output from an antenna. There is a problem in that the stable modulated radio carrier cannot be generated. In order to obtain the local oscillator capable of stably generating the oscillation frequency of at least 30 GHz, there are still drawbacks to be solved even with the use of current technology. In particular, an extremely advanced technology and a considerable cost are required for producing the local oscillator having a frequency range as high as 60 GHz in order to realize the millimeter-wave radio communication with a frequency range of 60 GHz, which is considered attractive these days.

WO 99/14853 A1 discloses an image rejection, subharmonic frequency converter, realized in microstrip, particularly adapted to be used in mobile communication equipment. The converter avails of two identical subharmonic mixers employing each one or two pairs of diodes in antiparallel, obtained on a same silica substrate, and of a structure of hybrids performing appropriate phase combination adapted to suppress the image band in the converted signal. The mixers include filtering structures preferably consisting, but not limited to the same, of stubs λ/4 long, at the local oscillator frequency, having a free end, in short or open circuit, respectively.

WO 02/07304 A2 discloses a frequency converter module that converts a first frequency to a second frequency. In one embodiment, an up-converter includes a mixer having at least one stub for reflecting harmonic energy back into the mixer so as to improve its efficiency.

EP 0495598 A1 discloses a mixer circuit having three terminals, and including an anti-parallel connected diode pair.

EP 0081818 A2 discloses an image reflection type microwave integrated circuit frequency converter which is low in conversion loss and which has good frequency characteristics.

US 4420839 discloses a hybrid ring useful in the microwave and millimeter wave regions as a mixer for producing an IF output signal in response to applied LO and RF input signals. The ring is designed to exhibit a narrow bandwidth at the LO signal port and a moderately broad bandwidth at the RF signal port.

JP-A-2001-308647 employs a DC bias for suppressing spurious second harmonic waves of an oscillator.

### SUMMARY OF THE INVENTION

It is a general object of the present invention to provide a harmonic mixer and a radio communication device having the same.

A more specific object of the present invention is to realize the radio communication with the use of a high frequency range at least 30 GHz at a low cost and with a simple configuration of the harmonic mixer and the radio communication device having the same, although it is considered hard to generate the stable local oscillation frequency for the radio communication of at least 30 GHz.

According to a first aspect of the present invention, there is provided a harmonic mixer, comprising an anti-parallel diode having two diodes connected in parallel in reverse directions between first and second ends, wherein: the first end is adapted to receive a local oscillation signal; the second end is adapted to receive an information signal; and in use, an output signal of the harmonic mixer including an up-converted information signal is available at the second end, characterised in that: the second end is further adapted to receive a DC bias for outputting a double harmonic wave of the local oscillation signal via the second end so that said output signal includes the double harmonic wave as well as the up-converted information signal, and the double harmonic wave and the up-converted information signal have an identical electric power.

According to a second aspect of the present invention, there is provided a radio communication device, comprising: a local oscillator operable to output a local oscillation signal; a terminal adapted to receive a DC bias; and a harmonic mixer according to the aforementioned first aspect of the present invention.

### BRIEF DESCRIPTION OF THE DRAWINGS

Preferred embodiments of the present invention will be described in detail with reference to the following drawings, wherein:
Fig. 1 is a block diagram showing a harmonic mixer in accordance with a first embodiment of the present invention;
Fig. 2 is a graph showing current-voltage characteristics of anti-parallel diode shown in Fig. 1;
Fig. 3 shows a frequency spectrum of an output signal of the harmonic mixer shown in Fig. 1;
Fig. 4 is a block diagram of a radio communication device in accordance with a second embodiment of the present invention;
Fig. 5 is a block diagram of another example of the radio communication device;
Fig. 6 is a circuit diagram of the harmonic mixer shown in Fig. 4; and
Fig. 7 is a circuit diagram of another example of the harmonic mixer shown in Fig. 6.

### DESCRIPTION OF THE PREFERRED EMBODIMENTS

A description will now be given, with reference to the accompanying drawings, of embodiments of the present invention.

Here, in the case where there is not a DC bias, which will be described later, a double harmonic wave component is cancelled in the APDP 202 in the above-mentioned operation, and does not appear at the external connection terminal 212 that serves as the output terminal. In contrast, a DC voltage supply 10 is connected to the other end of the APDP 202 through a terminal 214 in accordance with the first embodiment of the present invention. The DC voltage supply 10 serves as a bias supply to apply the DC voltage to the other end of the APDP 202. Thus, the APDP 202 is biased and the operation characteristics of the APDP 202 are offset. As a result, the double harmonic wave component 2•f_{LO} of the local oscillation frequency is not cancelled in the APDP 202, and is output. In another point of view, this output is a result of mixing the unmodulated signal having a zero frequency, namely, the DC voltage, with the local oscillation signals f_{LO}. In the case where f_{LO} is 30 GHz, 60 GHz of signal is output to the external connection terminal 212 through the capacitor C4.

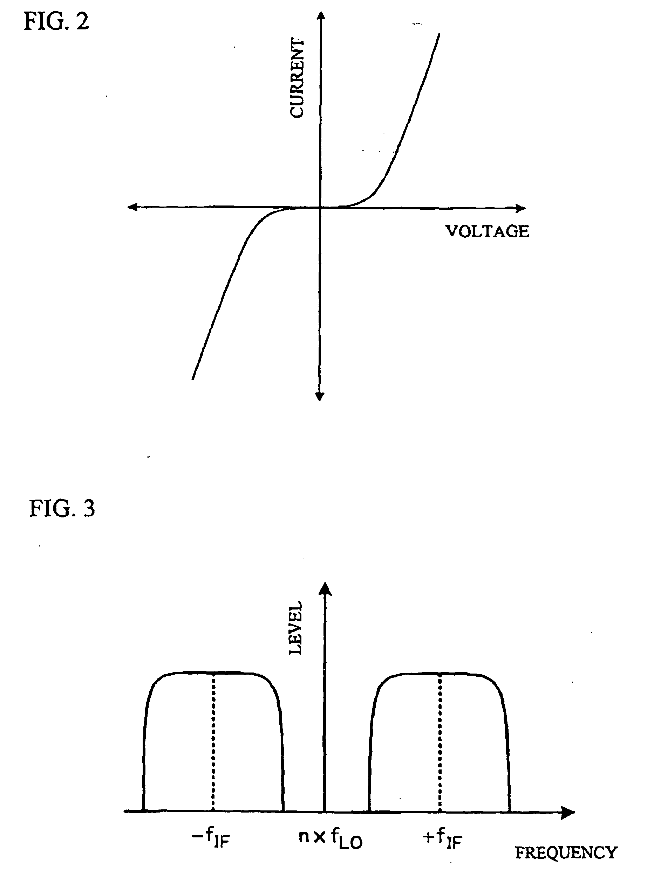

As described, the harmonic mixer 20 is capable of generating the signals of the frequencies n•f_{LO} ± f_{IF} (55 GHz and 65 GHz in the above-mentioned example), and the signal of the frequency n•f_{LO} (60 GHz in the above-mentioned example), as shown in Fig. 3. The signals of the frequencies n•f_{LO} ± f_{IF} are sent as the modulated radio signals, and the signal of the frequency n•f_{LO} is sent as the local oscillation signal for antenna transmission. In a receiver, the modulated radio signals are demodulated with the received local oscillation signal. The modulated radio signals include the same fluctuation components as that of the local oscillation signal transmitted through the antenna because these signals are generated by the APDP 202. The fluctuation components can be cancelled by demodulation. Also, the local oscillation signal of the frequency n·f_{LO} transmitted through the antenna can be generated with the local oscillator of the oscillation frequency f_{LO}. It is thus possible to realize the radio communication of at least 30 GHz stably with the simple configuration. The local oscillation signal transmitted through the antenna has the same electric power as that of the radio signal. If the electric powers are different, the fluctuation components might remain even after the cancellation. The electric power of the local oscillation signal transmitted through the antenna can be controlled easily by adjusting the voltage of the DC bias.

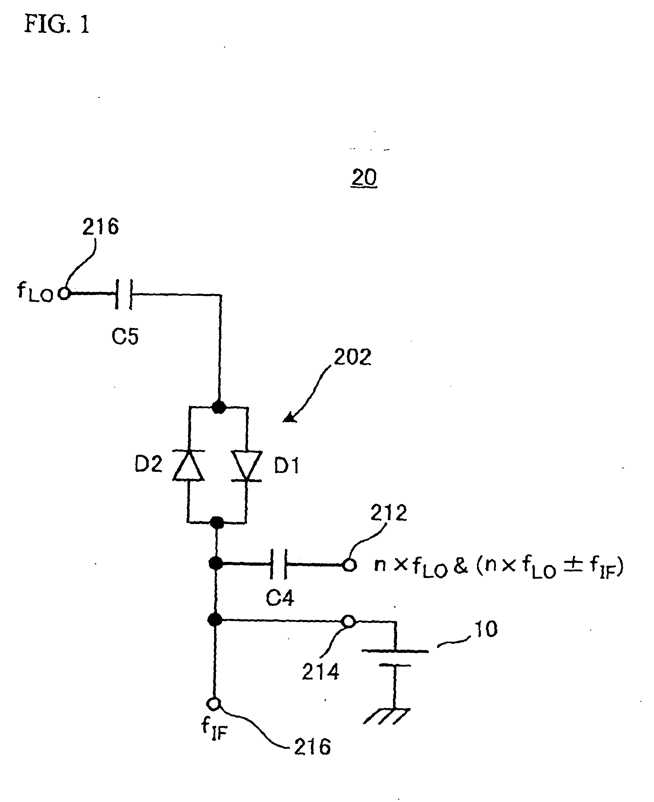

The capacitors C4 and C5 shown in fig. 1 are provided for blocking off the DC voltage applied from the DC voltage supply 10.

### (Second embodiment)

A description will be given of a radio communication device having the harmonic mixer 20 in accordance with a second embodiment of the present invention.

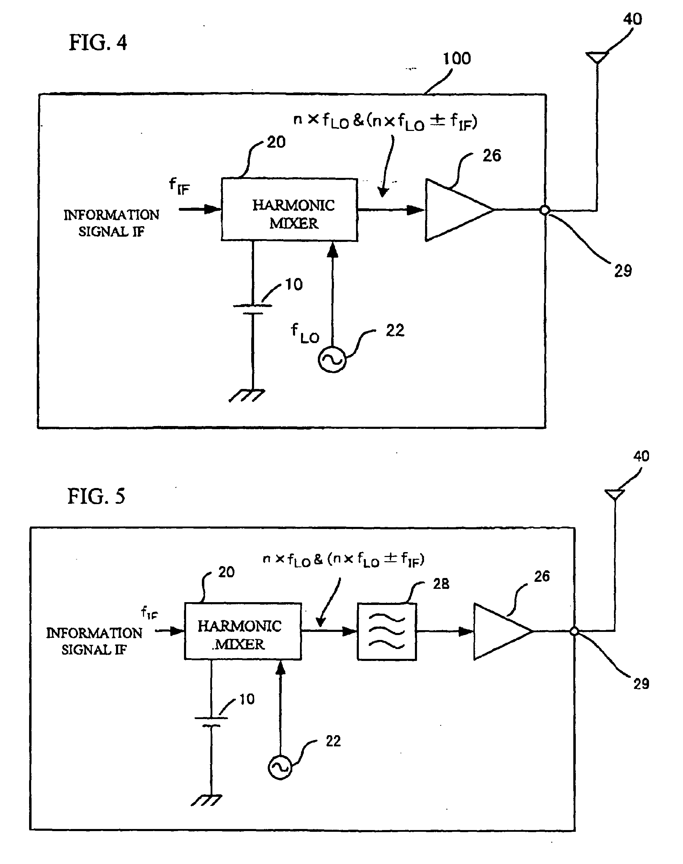

Fig. 4 is a block diagram of a radio communication device 100 in accordance with the second embodiment of the present invention. The radio communication device 100 includes the DC voltage supply 10, the harmonic mixer 20, a local oscillator 22, a power amplifier 26, and an external connection terminal 29. The local oscillator 22 generates the local oscillation signal of the frequency f_{LO}. The output signal is amplified by the power amplifier 26, and is transmitted via an antenna 40 connected to the external connection terminal 29. Referring to Fig. 5, a bandpass filter 28 is arranged in the front of the power amplifier 26, and thereby an undesired signal component can be eliminated. For example, the bandpass filter 28 is capable of eliminating the undesired waves other than the modulated radio signals of 2•f_{LO} ± f_{IF} and the local oscillation signal of 2•f_{LO} transmitted via the antenna, and is capable of eliminating one of the two modulated radio signals.

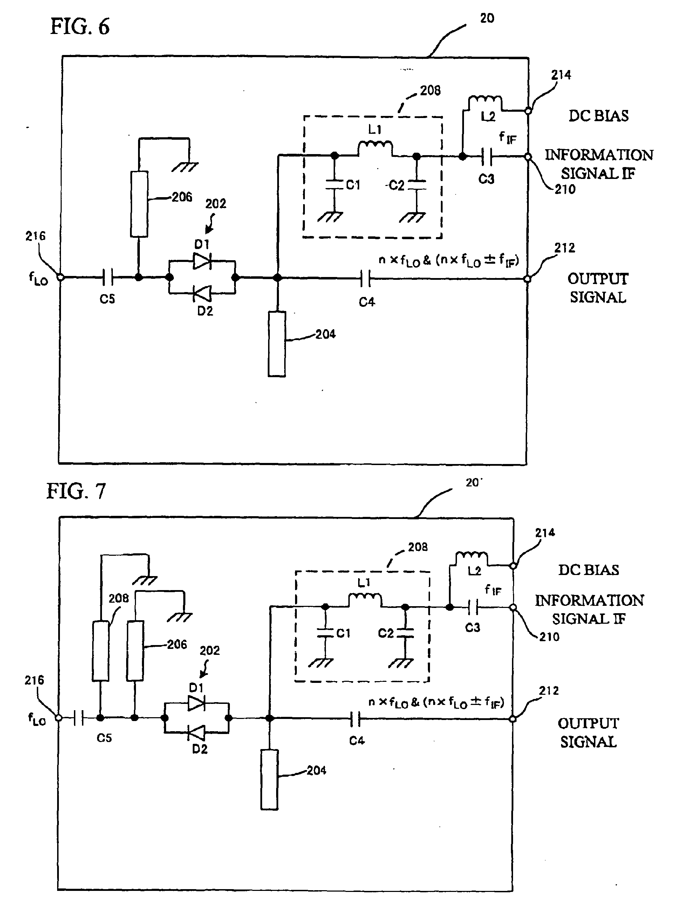

Fig. 6 is a circuit diagram of a configuration of the harmonic mixer 20. In order to facilitate the understanding of the circuit, circuit components are connected through ideal transmission lines. The output signal of the local oscillator 22 is applied to one end of the APDP 202 through the external connection terminal 216 and the capacitor C5. The information signal IF is applied to the other end of the APDP 202 through an external connection terminal 210, a decoupling capacitor C3, and a lowpass filter 208. The lowpass filter 208 includes two capacitors C1 and C2 and an inductor L1. The DC bias is applied to the other end of the APDP 202 through an external connection terminal 214, an inductor L2, and the lowpass filter 208. The inductor L2 prevents a high frequency component from being fed to the DC supply 10.

An open stub 204 and a short stub 206 are provided for suppressing a signal loss and improving the efficiency. The open stub 204 is connected to the output side of the APDP 202, and has a length equal to 1/4 of the wavelength corresponding to the local oscillation frequency f_{LO} generated by the local oscillator 22. Thus, the open end of the open stub 204 serves as ground, with respect to the signal of the local oscillation frequency f_{LO} (30 GHz in the above-mentioned example). It is thus possible to apply the signals of 30 GHz effectively across the APDP 202. The open stub 204 does not function with respect to the signal of 60 GHz at all. The short stub 206 is connected to the input side of the APDP 202, and has a length equal to 1/4 of the wavelength corresponding to either one of the modulated radio signals 2•f_{LO} ± f_{IF} (one of 55 GHz and 65 GHz in the above-mentioned example). For example, in the case where the short stub 206 has a length equal to 1/4 of the wavelength corresponding to the modulated radio signal of 65 GHz, the modulated radio signal of 65 GHz is effectively applied between the input side of the APDP 202 and the ground. Thus, the modulated radio signal of 65 GHz can be returned to the APDP 202. The short stub 206 may have a length equal to 1/4 of the wavelength corresponding to the modulated radio signal of 55 GHz. The modulated radio signal may transmit both sidebands or either sideband. In the case where only one of the sidebands is transmitted, one short stub 206 may be provided. In the case where both sidebands are transmitted, preferably, another short stub 208 is provided as shown in Fig. 7, so that the two short stubs 206 and 208 are respectively provided to the modulated radio signals of 55 GHz and 65 GHz.

It is thus possible to realize the radio communication with the use of the radio communication device 100 at a low cost and with a simple configuration for utilizing the high frequency range of at least 30 GHz.

The present invention is not limited to the above-mentioned embodiments, and other embodiments, variations and modifications may be made without departing from the scope of the present invention as defined in the appended claims.

## Claims

1. A harmonic mixer (20), comprising an anti-parallel diode (202) having two diodes (D1 and D2) connected in parallel in reverse directions between first and second ends, wherein:
the first end is adapted to receive a local oscillation signal;
the second end is adapted to receive an information signal; and
in use, an output signal of the harmonic mixer including an up-converted information signal is available at the second end,
**characterised in that**:
the second end is further adapted to receive a DC bias for outputting a double harmonic wave of the local oscillation signal via the second end so that said output signal includes the double harmonic wave as well as the up-converted information signal, wherein the voltage of the DC bias is adjusted so that the double harmonic wave and the up-converted information signal have an identical electric power.

2. The harmonic mixer as claimed in claim 1, further comprising an open stub (204) having a length equal to 1/4 of a wavelength of the harmonic wave included in the output signal, the open stub being connected to the second end.

3. The harmonic mixer as claimed in claim 1, further comprising a short stub (206) having a length equal to 1/4 of a wavelength of a signal obtained by up-converting the information signal with the harmonic wave included in the output signal, the short stub being connected to the first end.

4. The harmonic mixer as claimed in claim 1, further comprising:
an open stub (204) that has a length equal to 1/4 of a wavelength of the harmonic wave included in the output signal, and is connected to the second end; and
a short stub (206) that has a length equal to 1/4 of a wavelength of a signal obtained by up-converting the information signal with the harmonic wave included in the output signal, and is connected to the first end.

5. The harmonic mixer as claimed in claim 3, wherein the length of the short stub (206) is equal to 1/4 of a wavelength corresponding to a center frequency of one of two sidebands obtained by up-converting the information signal.

6. The harmonic mixer as claimed in claim 4, wherein the length of the short stub (206) is equal to 1/4 of a wavelength corresponding to a center frequency of one of two sidebands obtained by up-converting the information signal.

7. The harmonic mixer as claimed in claim 1, further comprising a lowpass filter (208) connected to the second end, the information signal being applied to the the anti-parallel diode through the lowpass filter.

8. The harmonic mixer as claimed in claim 1, further comprising a capacitor (C4) connected to the second end, the output signal being obtained through the capacitor.

9. The harmonic mixer as claimed in claim 1, further comprising a capacitor (C5) connected to the first end, the local oscillation signal being fed to the anti-parallel diode through the capacitor.

10. A radio communication device, comprising:
a local oscillator operable to output a local oscillation signal;
a terminal (214) adapted to receive a DC bias; and
a harmonic mixer (20) as claimed in any of claims 1 to 9.

## Patentansprüche

1. Harmonischer Mischer (20), der eine antiparallele Diode (202) umfasst, die zwei Dioden (D1 und D2) hat, die in entgegengesetzten Richtungen zwischen ersten und zweiten Enden parallel verbunden sind, bei dem:
das erste Ende dafür ausgelegt ist, um ein Lokaloszillatorsignal zu empfangen;
das zweite Ende dafür ausgelegt ist, um ein Informationssignal zu empfangen; und,
bei Gebrauch, ein Ausgangssignal des harmonischen Mischers, das ein aufwärts gemischtes Informationssignal enthält, am zweiten Ende zur Verfügung steht,
**dadurch gekennzeichnet, dass**:
das zweite Ende ferner dafür ausgelegt ist, um eine DC-Vorspannung zum Ausgeben einer doppelten harmonischen Welle des Lokaloszillatorsignals über das zweite Ende zu empfangen, so dass das Ausgangssignal die doppelte harmonische Welle sowie das aufwärts gemischte Informationssignal enthält, bei dem die Spannung der DC-Vorspannung so eingestellt ist, dass die doppelte harmonische Welle und das aufwärts gemischte Informationssignal eine identische elektrische Leistung haben.

2. Harmonischer Mischer nach Anspruch 1, der ferner eine offene Stichleitung (204) umfasst, die eine Länge von 1/4 einer Wellenlänge der in dem Ausgangssignal enthaltenen harmonischen Welle hat, welche offene Stichleitung mit dem zweiten Ende verbunden ist.

3. Harmonischer Mischer nach Anspruch 1, der ferner eine kurzgeschlossene Stichleitung (206) umfasst, die eine Länge von 1/4 einer Wellenlänge eines Signals hat, das durch Aufwärtsmischen des Informationssignals mit der in dem Ausgangssignal enthaltenen harmonischen Welle erhalten wird, welche kurzgeschlossene Stichleitung mit dem ersten Ende verbunden ist.

4. Harmonischer Mischer nach Anspruch 1, der ferner umfasst:
eine offene Stichleitung (204), die eine Länge von 1/4 einer Wellenlänge der in dem Ausgangssignal enthaltenen harmonischen Welle hat und mit dem zweiten Ende verbunden ist; und
eine kurzgeschlossene Stichleitung (206), die eine Länge von 1/4 einer Wellenlänge eines Signals hat, das durch Aufwärtsmischen des Informationssignals mit der in dem Ausgangssignal enthaltenen harmonischen Welle erhalten wird, und mit dem ersten Ende verbunden ist.

5. Harmonischer Mischer nach Anspruch 3, bei dem die Länge der kurzgeschlossenen Stichleitung (206) 1/4 einer Wellenlänge entsprechend einer Mittenfrequenz von einem von zwei Seitenbändern beträgt, die durch Aufwärtsmischen des Informationssignals erhalten werden.

6. Harmonischer Mischer nach Anspruch 4, bei dem die Länge der kurzgeschlossenen Stichleitung (206) 1/4 einer Wellenlänge entsprechend einer Mittenfrequenz von einem von zwei Seitenbändern beträgt, die durch Aufwärtsmischen des Informationssignals erhalten werden.

7. Harmonischer Mischer nach Anspruch 1, der ferner ein Tiefpassfilter (208) umfasst, das mit dem zweiten Ende verbunden ist, wobei das Informationssignal durch das Tiefpassfilter auf die antiparallele Diode angewendet wird.

8. Harmonischer Mischer nach Anspruch 1, der ferner einen Kondensator (C4) umfasst, der mit dem zweiten Ende verbunden ist, wobei das Ausgangssignal durch den Kondensator erhalten wird.

9. Harmonischer Mischer nach Anspruch 1, der ferner einen Kondensator (C5) umfasst, der mit dem ersten Ende verbunden ist, wobei das Lokaloszillatorsignal durch den Kondensator zu der antiparallelen Diode zugeführt wird.

10. Funkkommunikationsvorrichtung, umfassend:
einen Lokaloszillator, der betriebsfähig ist, um ein Lokaloszillatorsignal auszugeben;
einen Anschluss (214), der dafür ausgelegt ist, um eine DC-Vorspannung zu empfangen; und
einen harmonischen Mischer (20) nach einem der Ansprüche 1 bis 9.

## Revendications

1. Mélangeur harmonique (20), comprenant une diode en anti-parallèle (202) comportant deux diodes (D1 et D2) connectées en parallèle dans des directions inverses entre des première et deuxième extrémités, dans lequel :
la première extrémité est conçue pour recevoir un signal d'oscillation local ;
la deuxième extrémité est conçue pour recevoir un signal d'informations ; et
en utilisation, un signal de sortie du mélangeur harmonique comprenant un signal d'informations converti-élevé est disponible à la deuxième extrémité,
**caractérisé en ce que** :
la deuxième extrémité est en outre conçue pour recevoir une polarisation continue pour délivrer une onde harmonique double du signal d'oscillation local par l'intermédiaire de la deuxième extrémité de sorte que ledit signal de sortie comprenne l'onde harmonique double ainsi que le signal d'informations converti-élevé, dans lequel la tension de la polarisation continue est ajustée de sorte que l'onde harmonique double et le signal d'informations converti-élevé aient une puissance électrique identique.

2. Mélangeur harmonique selon la revendication 1, comprenant en outre un tronçon de ligne ouvert (204) ayant une longueur égale à 1/4 d'une longueur d'onde de l'onde harmonique incluse dans le signal de sortie, le tronçon de ligne ouvert étant connecté à la deuxième extrémité.

3. Mélangeur harmonique selon la revendication 1, comprenant en outre un tronçon de ligne en court-circuit (206) ayant une longueur égale à 1/4 d'une longueur d'onde d'un signal obtenu par conversion-élévation du signal d'informations avec l'onde harmonique incluse dans le signal de sortie, le tronçon de ligne en court-circuit étant connecté à la première extrémité.

4. Mélangeur harmonique selon la revendication 1, comprenant en outre :
un tronçon de ligne ouvert (204) qui a une longueur égale à 1/4 d'une longueur d'onde de l'onde harmonique incluse dans le signal de sortie, et qui est connecté à la deuxième extrémité ; et
un tronçon de ligne en court-circuit (206) qui a une longueur égale à 1/4 d'une longueur d'onde d'un signal obtenu en convertissant-élevant le signal d'informations avec l'onde harmonique incluse dans le signal de sortie, et qui est connecté à la première extrémité.

5. Mélangeur harmonique selon la revendication 3, dans lequel la longueur du tronçon de ligne en court-circuit (206) est égale à 1/4 d'une longueur d'onde correspondant à une fréquence centrale de l'une des deux bandes latérales obtenues en convertissant-élevant le signal d'informations.

6. Mélangeur harmonique selon la revendication 4, dans lequel la longueur du tronçon de ligne en court-circuit (206) est égale à 1/4 d'une longueur d'onde correspondant à une fréquence centrale de l'une des deux bandes latérales obtenues en convertissant-élevant le signal d'informations.

7. Mélangeur harmonique selon la revendication 1, comprenant en outre un filtre passe-bas (208) connecté à la deuxième extrémité, le signal d'informations étant appliqué à la diode en anti-parallèle par l'intermédiaire du filtre passe-bas.

8. Mélangeur harmonique selon la revendication 1, comprenant en outre un condensateur (C4) connecté à la deuxième extrémité, le signal de sortie étant obtenu par l'intermédiaire du condensateur.

9. Mélangeur harmonique selon la revendication 1, comprenant en outre un condensateur (C5) connecté à la première extrémité, le signal d'oscillation local étant appliqué à la diode en anti-parallèle par l'intermédiaire du condensateur.

10. Dispositif de radiocommunication, comprenant :
un oscillateur local pouvant être utilisé pour délivrer un signal d'oscillation local ;
une borne (214) conçue pour recevoir une polarisation continue ; et
un mélangeur harmonique (20) selon l'une quelconque des revendications 1 à 9.
